# EUROPÄISCHE PATENTSCHRIFT

(11) **EP 3 877 769 B1**
(45) Veröffentlichungstag und Bekanntmachung des Hinweises auf die Patenterteilung: **11.10.2023**
(21) Anmeldenummer: 19804659.1
(22) Anmeldetag: 07.11.2019
(51) Int. Cl.: G01R 15/18

(54) **SIGNALAUFBEREITUNGSSCHALTUNG**
SIGNAL-PROCESSING CIRCUIT
CIRCUIT DE CONDITIONNEMENT DE SIGNAUX

(30) Priorität: 09.11.2018 AT 509662018
(43) Veröffentlichungstag der Anmeldung: 15.09.2021
(73) Patentinhaber: Egston System Electronics Eggenburg GmbH, 3730 Eggenburg (AT)
(72) Erfinder: TRETHAN, Stefan, 3720 Ravelsbach (AT); JAMY, Roman, 3593 Neupölla (AT)
(74) Vertreter: Gibler & Poth Patentanwälte KG
(86) Internationale Anmeldenummer: PCT/EP2019/080596
(87) Internationale Veröffentlichungsnummer: WO 2020/094811

(56) Entgegenhaltungen:
- EP-A1- 2 810 088
- DE-A1-102018 201 310
- YUTTHAGOWITH PEERAWUT ET AL: "A rogowski coil with an active integrator for measurement of long duration impulse currents", 2014 INTERNATIONAL CONFERENCE ON LIGHTNING PROTECTION (ICLP), IEEE, 11. Oktober 2014 (2014-10-11), Seiten 1761-1765, XP032695939, DOI: 10.1109/ICLP.2014.6973414 [gefunden am 2014-12-03]

## Beschreibung

Die Erfindung betrifft eine Signalaufbereitungsschaltung gemäß dem Oberbegriff des Patentanspruches 1.

Es ist bekannt Spulen als Sensoren zur Strommessung zu verwenden. Dabei haben sich insbesondere Luftspulen bzw. sog. Rogowskispulen als Vorteilhaft erwiesen. Eine Rogowskispule gibt an deren Ausgang das Differential des gemessenen Stromes als Spannung aus. Es ist daher erforderlich ein derartiges Messsignal mittels einer nachfolgenden Integration aufzubereiten.

Es sind sowohl aktive als auch passive Schaltungen zur Integration eines Signals bekannt. Weiters ist es bekannt, für das Erfassen bzw. Messen von Strömen hoher Dynamik einen aktiven Integrator und ein passives Integrierglied zu kombinieren. Dabei hat sich gezeigt, dass zur Ausbildung des aktiven Integrators die Verwendung der weithin bekannten invertierenden Integrator-Operationsverstärkerschaltung erhebliche Nachteile aufweist, wenn Signale mit großem Spannungshub am Eingang einer derartigen Schaltung anliegen.

Aus der US 6 614 218 B1 (Ray) sowie aus der Veröffentlichung: Pettinga, et al., "A polyphase 500kA current measuring system with Rogowski coils" sind jeweils Signalaufbereitungsschaltungen bekannt, welche ein passives Integrierglied mit einem aktiven Integrator kombinieren, wobei der aktive Integrator jeweils als nichtinvertierender Integrator ausgebildet ist.

Es hat sich jedoch gezeigt, dass derartige Signalaufbereitungsschaltungen nach wie vor erhebliche Probleme hinsichtlich der erzielbaren Messgenauigkeit haben, sofern in einem Eingangssignal Signalanteile mit sehr hoher Flankensteilheit bzw. Slew-Rate, beispielsweise größer 10 kA/µs ist, enthalten sind. Derartig steile Signalanteile können zu einem Integrationsfehler am aktiven Integrator führen, und dadurch erhebliche Fehler verursachen, welche ein Messergebnis komplett unbrauchbar machen.

Derartige steil ansteigende Signalanteile sind insbesondere in Blitzströmen enthalten. Dies führt dazu, dass reale bzw. tatsächlich in der Natur auftretende Blitze bislang nicht mittels Rogowskispulen gemessen werden konnten, da die bekannten Signalaufbereitungsschaltungen einen Blitzstromes nicht ausreichend genau abbilden bzw. dessen spektrale Verteilung sowie dessen dynamisches Zeitverhalten verfälschen. Deshalb werden reale Blitzströme derzeit mit sehr großen, voluminösen und aufwendigen Shunt-Widerständen, welche der Verlustleistung eines Blitzes standhalten müssen, gemessen. Aufgrund der erheblichen Kosten derartiger Shunt-Widerstände sind Systeme zum Messen realer Blitze kaum verbreitet, und werden in erster Linie für Forschungszwecke verwendet. Dabei ist zu beachten, dass derartige Messsysteme aufgrund deren Masse, Abmessungen und des Installationsaufwandes stets fest verbaut und nicht mobil einsetzbar sind.

Eine breitenwirksame Anwendung von Blitzstrommesssystemen ist auf Basis von Shunt-Widerständen nicht möglich. Allerdings wäre der Einsatz von Blitzstrommesssystemen zumindest bei exponierten Gebäuden, wie etwa Windrädern, sowohl aus Sicht der Forschung als auch der Versicherungen wünschenswert. Dadurch könnten die, durch einen Blitz verursachten Schäden in einen Zusammenhang mit den auftretenden Strömen gebracht werden.

Die IEEE Veröffentlichung: "A Rogowski coil with an active integrator for measurement of long duration impulse currents" von Yutthagowith Peerawut et al. beschreibt einen nicht-invertierenden aktiven Inverter mit einer Rogowskispule.

Die EP 2 810 088 A1 beschreibt eine Schaltanordnung für Strommessung mit einer Temperaturkompensation.

Aufgabe der Erfindung ist es daher eine Signalaufbereitungsschaltung der eingangs genannten Art anzugeben, mit welcher die genannten Nachteile vermieden werden können, und mit welcher Ströme mit großem Dynamikbereich sowie mit stark ansteigenden Signalen bzw. hoher Flankensteilheit mittels einer Strommessspule gemessen werden können.

Erfindungsgemäß wird dies durch die Merkmale des Patentanspruches 1 erreicht.

Dadurch können auch Ströme mit großem Dynamikbereich sowie mit Signalanteilen, welche eine hohe Flankensteilheit bzw. eine hohe Slew-Rate, insbesondere größer 10 kA/µs, aufweisen, mittels einer Strommessspule messtechnisch genau erfasst und gemessen werden. Dadurch kann verhindert werden, dass Signalanteile mit hoher Slew-Rate zu Fehlern am aktiven Integrator führen. Durch das zweite passive Integrierglied werden steilflankige Signale deutlich stärker gedämpft, als bisher, wodurch der aktive Integrator nur noch Signale mit deutlich geringerer Slew-Rate bzw. Signalanstiegszeit verarbeiten muss. Durch das Differentierglied wird die Wirkung des zweiten passiven Integriergliedes auf den Frequenzgang wieder kompensiert.

Dadurch können selbst hochdynamische Ströme wie reale Blitze mittels Rogowskispulen gemessen werden, wodurch der Aufwand für das Messen von Blitzen bzw. Blitzströmen deutlich verringert wird. Dadurch können deutlich mehr exponierte Anlagen mit einem Blitzstrommesssystem ausgestattet werden. Dadurch kann das Wissen um die Eigenschaften und Auswirkungen von Blitzen erhöht werden. Dadurch können Erkenntnisse gewonnen werden, durch deren Anwendung die Sicherheit von Menschen und Anlage gegen die Auswirkungen von Blitzschlägen erhöht werden kann.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 ein Blockschaltbild einer bevorzugten Ausführungsform eines gegenständlichen Strommesssystems mit einer gegenständlichen Signalaufbereitungsschaltung;
Fig. 2 ein Blockschaltbild einer bevorzugten Ausführungsform des ersten Integriergliedes; und
Fig. 3 ein schematischer Stromlaufplan des Strommesssystems nach Fig. 1 ohne Spannungsüberwachungseinheit.

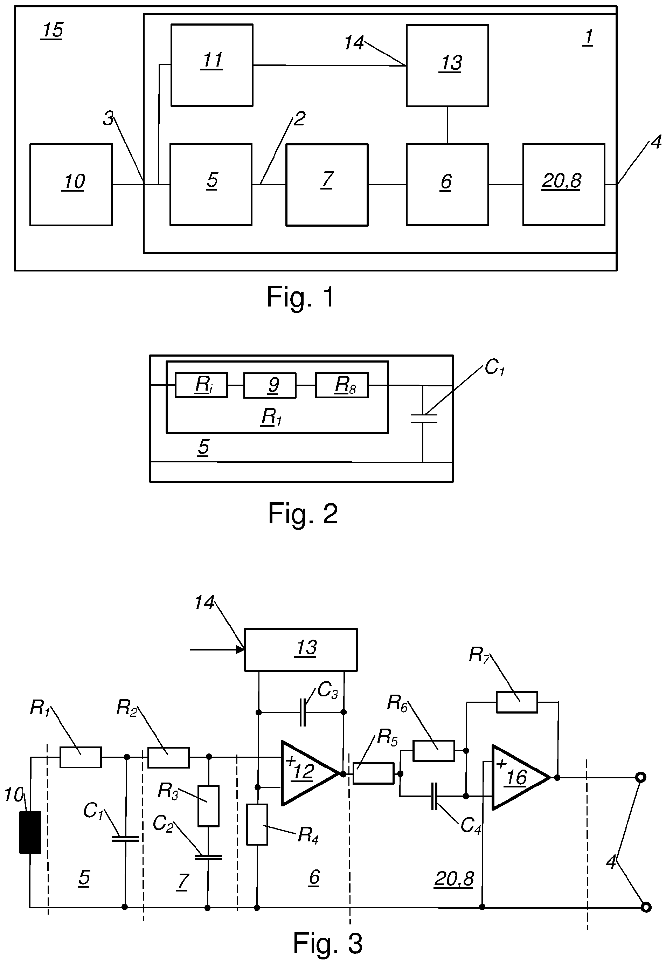

Die Fig. 1 und 3 zeigen jeweils ein Strommesssystem 15 mit einer Signalaufbereitungsschaltung 1 mit wenigstens einem Signalpfad 2 zwischen einem Eingang 3 und einem Ausgang 4 der Signalaufbereitungsschaltung 1, wobei der Signalpfad 2 ein erstes passives Integrierglied 5 und einen aktiven Integrator 6 aufweist, wobei der aktive Integrator 6 als nichtinvertierender aktiver Integrator 6 ausgebildet ist, wobei das erste passive Integrierglied 5 und der aktive Integrator 6 seriell innerhalb des Signalpfades 2 geschaltet sind, wobei der Signalpfad 2 weiters ein zweites passives Integrierglied 7 sowie ein Differentierglied 20 aufweist.

Dadurch können auch Ströme mit großem Dynamikbereich sowie mit Signalanteilen, welche eine hohe Flankensteilheit bzw. eine hohe Slew-Rate, insbesondere größer 10 kA/µs, aufweisen, mittels einer Strommessspule 10 messtechnisch genau erfasst und gemessen werden. Dadurch kann verhindert werden, dass Signalanteile mit hoher Slew-Rate zu Fehlern am aktiven Integrator 6 führen. Durch das zweite passive Integrierglied 7 werden steilflankige Signale deutlich stärker gedämpft, als bisher, wodurch der aktive Integrator 6 nur noch Signale mit deutlich geringerer Slew-Rate bzw. Signalanstiegszeit verarbeiten muss. Durch das Differentierglied 20 wird die Wirkung des zweiten passiven Integriergliedes 7 auf den Frequenzgang wieder kompensiert.

Dadurch können selbst hochdynamische Ströme wie reale Blitze mittels Rogowskispulen gemessen werden, wodurch der Aufwand für das Messen von Blitzen bzw. Blitzströmen deutlich verringert wird. Dadurch können deutlich mehr exponierte Anlagen mit einem Blitzstrommesssystem ausgestattet werden. Dadurch kann das Wissen um die Eigenschaften und Auswirkungen von Blitzen erhöht werden. Dadurch können Erkenntnisse gewonnen werden, durch deren Anwendung die Sicherheit von Menschen und Anlage gegen die Auswirkungen von Blitzschlägen erhöht werden kann.

Eine gegenständliche Signalaufbereitungsschaltung 1 dient dazu ein Eingangssignal mit einem weiten Dynamikbereich, über einen weiten Frequenzbereich zu integrieren. Insbesondere ist die gegenständliche Signalaufbereitungsschaltung 1 dazu ausgebildet und vorgesehen Messsignale zu verarbeiten, die von einer Strommessspule 10, welche als Sensor dient, stammt. Insbesondere ist vorgesehen, dass diese Strommessspule 10 eine Rogowskispule ist. Allerdings kann mit der gegenständlichen Signalaufbereitungsschaltung 1 jegliches Signal integriert werden, unabhängig von dessen Herkunft bzw. der Art und Ausbildung des Sensors, der das betreffende Signal erzeugt hat oder eines Speichermediums, auf dem das Signal abgelegt ist. Selbstverständlich muss das betreffende Signal innerhalb der maximalen Belastungsgrenzen liegen, für welche eine konkrete Ausführung der Signalaufbereitungsschaltung 1 dimensioniert ist. Die gegenständliche Signalaufbereitungsschaltung 1 ist daher bevorzugt nicht auf den Einsatz in bzw. als Teil eines Strommesssystems 15, insbesondere eines Blitzstrommesssystems, beschränkt.

Die Signalaufbereitungsschaltung 1 weist einen Eingang 3 und einen Ausgang 4 auf, sowie einen Signalpfad 2 zwischen dem Eingang 3 und dem Ausgang 4. Wenngleich der Signalpfad 2 in dem Blockschaltbild gemäß Fig. 1 lediglich mit einer einzigen Linie dargestellt ist, umfasst der Signalpfad 2 - wie in Fig. 3 dargestellt - bevorzugt eine signalführende Leitung 17, sowie weiters eine Bezugspotentialleitung 18.

Der Eingang 3 ist insbesondere dazu vorgesehen, dass an diesen eine Strommessspule 10 angeschlossen wird. Dabei ist insbesondere vorgesehen, dass eine bestimmte Signalaufbereitungsschaltung 1 zur Signalaufbereitung der Messsignale einer bestimmten Strommessspule 10 ausgebildet ist. Dies ist insbesondere in Hinblick auf die Berücksichtigung des Innenwiderstandes Rᵢ der Strommessspule 10 sowie deren thermischen Verhaltens bevorzugt vorgesehen. Wie jeder reale, passive Bauteil, weist auch die Strommessspule 10 einen Innenwiderstand Rᵢ auf. Strommessspulen 10, wie beispielsweis die bevorzugt vorgesehenen Rogowskispulen, weisen einen positiven Temperaturkoeffizienten auf. Die gegenständliche Signalaufbereitungsschaltung 1 vor allem dazu vorgesehen ist Blitzströme zu messen. Dafür wird die Strommessspule 10 fest an einem bestimmten Punkt, etwa einem Gebäude oder einem Windrad, angeordnet bzw. installiert. Die Strommessspule 10 ist dann den wetterbedingten Schwankungen der Umgebungstemperatur ausgesetzt. Da dies in der Regel zu einem Abkühlen oder einem Erwärmen der Strommessspule 10 führt, ist bevorzugt vorgesehen, dass das Verhalten der Strommessspule 10 bei Erwärmung mit berücksichtigt wird.

Der Signalpfad 2 weist ein erstes passives Integrierglied 5 auf, welches bevorzugt als erste Baugruppe nach dem Eingang 3 angeordnet ist. Dieses erste passive Integrierglied 5 ist bevorzugt als Tiefpass umfassend einen ersten Widerstand R₁ ausgebildet. Bei der bevorzugten Ausbildung als passiver Tiefpass erster Ordnung weist das erste passive Integrierglied 5 weiters lediglich einen ersten Kondensator C1 auf, wie in Fig. 2 und 3 dargestellt, und wie an sich bekannt.

Der erste Widerstand R₁ ist bevorzugt durch eine Serienschaltung mehrerer Widerstände ausgebildet. Dabei ist vorgesehen, dass der Innenwiderstand Rᵢ der Strommessspule 10 Teil des ersten Widerstandes R₁ ist. Weiters weist der erste Widerstand R₁ bevorzugt einen diskreten Festwiderstand R₈ auf, welcher gegenständlich auch als achter Widerstand R₈ bezeichnet werden kann.

Zudem ist besonders bevorzugt vorgesehen, dass die Signalaufbereitungsschaltung 1 eine Temperaturkompensationsschaltung 9 zur Kompensation des temperaturabhängigen Innenwiderstandes Rᵢ einer vorgebbaren, an den Eingang anschließbaren Strommessspule 10 aufweist. Diese Temperaturkompensationsschaltung 9 ist insbesondere am Eingang 3 angeordnet, und bildet besonders bevorzugt, und wie in Fig. 2 dargestellt, einen Teil des ersten Widerstands R₁. Der erste Widerstand R₁ ist in der signalführenden Leitung 17 angeordnet.

Die Temperaturkompensationsschaltung 9 kann an sich als jede Art einer Schaltung zur Kompensation zw. zum Ausgleich des PTC-Verhaltens der Strommessspule 10 ausgebildet sein. Bevorzugt umfasst die Temperaturkompensationsschaltung 9 wenigstens einen NTC-Widerstand. Besonders bevorzugt ist die Temperaturkompensationsschaltung 9 umfassend eine vorgebbare Anzahl miteinander verschalteter NTC-Widerstände ausgebildet.

Der Signalpfad 2 weist weiters einen aktiven Integrator 6 auf, welcher in dem Signalpfad 2 seriell zu dem ersten passiven Integrierglied 5 geschaltet ist. Der aktive Integrator 6 ist als nichtinvertierender aktiver Integrator 6 ausgebildet. Der aktive Integrator 6 weist bevorzugt wenigstens einen ersten Operationsverstärker 12 auf. Die signalführende Leitung 17 liegt an dem nichtinvertierenden Eingang des ersten Operationsverstärkers 12 an. Der invertierende Eingang des Operationsverstärkers 12 ist über den vierten Widerstand R₄ mit dem Bezugspotential 18 verbunden. Weiters weist der aktive Integrator 6 den Rückkopplungs-Kondensator C₃ auf, welcher den Ausgang des ersten Operationsverstärkers 12 mit dessen invertierenden Eingang verbindet. Der Rückkopplungs-Kondensator C₃ kann gegenständlich auch als dritter Kondensator C₃ bezeichnet werden.

Für ein besonders exaktes Funktionieren des aktiven Integrators 6 ist es wichtig, dass der Rückkopplungs-Kondensator C₃ nicht geladen ist, dass also die Spannung über den Rückkopplungs-Kondensator C₃ am Beginn einer Messung null ist. Bei der bevorzugten Anwendung der gegenständlichen Signalaufbereitungsschaltung 1 als Teil eines Blitzstrommesssystems ist davon auszugehen, dass über lange Zeiträume keine Messsignale zu verarbeiten sind. Dies kann zur Folge haben, dass der Rückkopplungs-Kondensator C₃ einen undefinierten Ladungszustand einnimmt, welcher bei einer plötzlich durchzuführenden Messung zu erheblichen Verfälschungen der Messergebnisse führen würde. Es ist daher bevorzugt vorgesehen, dass die Signalaufbereitungsschaltung 1 weiters eine aktive Regeleinheit 13 aufweist, welche mit dem Rückkopplungs-Kondensator C₃ verbunden ist. Diese aktive Regeleinheit 13 ist dabei derart ausgebildet, dass diese die Spannung über den Rückkopplungs-Kondensator C₃ unter einem vorgebbaren Wert, insbesondere im Wesentlichen auf null, regelt. Die aktive Regeleinheit 13 kann dabei beispielsweise umfassend eine programmierbare Steuerung bzw. umfassend einen Mikrocontroller ausgebildet sein. Durch die aktive Regeleinheit 13 kann dafür gesorgt werden, dass es bei Anliegen eines Messsignal zu keinen Verfälschungen aufgrund einer Ladung des Rückkopplungs-Kondensators C₃ kommt.

Die aktive Regeleinheit 13 soll nur in den Zeiten verwendet werden, in denen kein vorgebbares Messsignal an der Signalaufbereitungsschaltung 1 anliegt. Es ist daher weiters bevorzugt vorgesehen, dass die Signalaufbereitungsschaltung 1 eine Spannungsüberwachungseinheit 11 aufweist, welche mit dem Eingang 3 verbunden ist. Die Spannungsüberwachungseinheit 11, welche lediglich schematisch in Fig. 1 dargestellt ist, überwacht die am Eingang 3 anliegende elektrische Spannung, und ist derart ausgebildet, dass diese bei Auftreten einer vorgebbaren Spannung am Eingang 3 ein Trigger-Signal ausgibt.

In diesem Zusammenhang ist weiters bevorzugt vorgesehen, dass die Spannungsüberwachungseinheit 11 mit einem Betriebseingang 14 der Regeleinheit 13 verbunden ist, um die Regeleinheit 13 auszuschalten bzw. außer Betrieb zu nehmen, sobald ein vorgebbar großes Messsignal am Eingang 3 anliegt. Die aktive Regeleinheit 13 ist daher zusammen mit der Spannungsüberwachungseinheit 11 derart ausgebildet, dass sich die aktive Regeleinheit 13 bei Anliegen des Trigger-Signals am Betriebseingang 14 abschaltet.

Hinsichtlich des konkreten Trigger-Signals sind die Spannungsüberwachungseinheit 11 und die aktive Regeleinheit 13 aufeinander abzustimmen.

Es ist vorgesehen, dass der Signalpfad 2 weiters ein zweites passives Integrierglied 7 sowie ein Differentierglied 20 aufweist. Das zweite passive Integrierglied sowie das Differentierglied 20 sind schaltungstechnisch seriell zum ersten passiven Integrierglied 5 sowie dem aktiven Integrator 6 angeordnet. Dabei ist insbesondere vorgesehen, dass das Differentierglied 20 dem aktiven Integrator 6 seriell nachgeschaltet ist, wobei jedoch auch eine, von der Anordnung gemäß Fig. 1 und 3 abweichende Anordnung der einzelnen Baugruppen vorgesehen sein kann.

Das Differentierglied 20 kann als passives Differentierglied 20 ausgebildet sein. Besonders bevorzugt, und wie in Fig. 3 im Detail dargestellt, ist jedoch vorgesehen, dass das Differentierglied 20 als aktiver Differentiator 8 ausgebildet ist. Nachfolgend wird die Erfindung zusammen mit einem aktiven Differentiator 8 beschrieben, wobei jedoch jeweils auch der Einsatz eines passiven Differentierglieds 20 vorgesehen sein kann.

Die gegenständliche Signalaufbereitungsschaltung 1 weist in deren Signalpfad 2 ein erstes passives Integrierglied 5 und ein zweites passives Integrierglied 7 sowie einen aktiven Integrator 6 und einen aktiven Differentiator 8 auf. Diese vier Komponenten 5, 6, 7, 8 sind dabei derart aufeinander abzustimmen, dass diese zusammen eine möglichst nahtlose Integration eines breitbandigen Eingangssignals durchführen. Dies erfolgt insbesondere durch die jeweilige Auslegung hinsichtlich der Übergabefrequenzen.

Der aktive Integrator 6 dient dabei der Integration der sog. langsamen Signalanteile, also von Signalanteilen eines anliegenden Messsignals mit niedrigen Frequenzen bzw. geringer Slew-Rate. Dabei ist insbesondere vorgesehen, dass der aktive Integrator 6 zur Integration von Signalanteilen eines Eingangs- oder Messsignals mit einer Frequenz zwischen 0 Hz (DC bzw. Gleichstrom) und einer ersten Grenzfrequenz f_{g1} ausgebildet und entsprechend dimensioniert ist.

Das erste passive Integrierglied 5 ist zur Integration von Signalanteilen mit einer Frequenz oberhalb der ersten Grenzfrequenz f_{g1} ausgebildet, und ist entsprechend abzustimmen bzw. auszulegen. Das erste passive Integrierglied (5) dient daher der Integration hochfrequenter bzw. "schneller" Signalanteile, und wirkt auf den gesamten Frequenzbereich größer der ersten Grenzfrequenz f_{g1}.

Das zweite passive Integrierglied 7 ist zur Integration von Signalanteilen des Eingangssignals mit einer Frequenz ausgebildet, welche lediglich zwischen der ersten Grenzfrequenz f_{g1} und einer zweiten Grenzfrequenz f_{g2} liegt, wobei die zweite Grenzfrequenz f_{g2} größer der ersten Grenzfrequenz f_{g1} ist. In diesem Frequenzbereich zwischen der ersten Grenzfrequenz f_{g1} und der zweiten Grenzfrequenz f_{g2} wirken daher sowohl das erste passive Integrierglied 5 als auch das zweite passive Integrierglied 7 auf die entsprechenden Signalanteile. Dadurch kann, wie bereits dargelegt, die Funktion bzw. die Genauigkeit des aktiven Integrators 6 deutlich gesteigert werden, indem Signale mit sehr hohen Slew-Rates abgeschwächt werden.

Das zweite passive Integrierglied 7 ist dabei derart ausgebildet, dass dies in dessen Wirkung bei bzw. ab der zweiten Grenzfrequenz f_{g2} wieder beschränkt wird. Fig. 3 zeigt eine mögliche Ausführungsform des zweiten passiven Integrierglieds 7, welches dabei zusätzlich zu dem obligatorischen zweiten Widerstand R₂ und dem zweiten Kondensator C₂ weiters den dritten Widerstand R₃ aufweist, welcher seriell zum zweiten Kondensator C₂ geschaltet ist, und welcher die Wirkung des zweiten Kondensators C₂ bei höheren Frequenzen beschränkt, sodass das zweite passive Integrierglied 7 oberhalb der zweiten Grenzfrequenz f_{g2} nicht mehr wirksam ist.

Bevorzugt ist vorgesehen, dass das zweite passive Integrierglied 7 schaltungstechnisch zwischen dem ersten passiven Integrierglied 5 und dem aktiven Integrator 6 angeordnet ist.

Der aktive Differentiator 8 dient der Kompensation der integrierenden Wirkung des zweiten passiven Integriergliedes 7. Der aktive Differentiator 8 ist daher bevorzugt zur Differentiation von Signalanteilen des Eingangssignals lediglich zwischen der ersten Grenzfrequenz f_{g1} und der zweiten Grenzfrequenz f_{g2} ausgebildet. Dabei sollen lediglich die Signalanteile in diesem Frequenzbereich differenziert werden.

Fig. 3 zeigt eine bevorzugte Umsetzung eines gegenständlichen aktiven Differentiators 8. Dieser umfasst einen zweiten Operationsverstärker 16. Zwischen dem aktiven Integrator 6 und dem Eingang des zweiten Operationsverstärkers 16 sind der fünfte Widerstand R₅ sowie der vierte Kondensator C₄ angeordnet. Durch den, parallel zum vierten Kondensator C₄ geschalteten, sechsten Widerstand R₆ kann erreicht werden, dass die Wirkung des aktive Differentiators 8 auf einen bestimmten Frequenzbereich, gegenständlich den Bereich zwischen der ersten Grenzfrequenz f_{g1} und der zweiten Grenzfrequenz f_{g2}, beschränkt bleibt. Weiters verbindet der siebente Widerstand R₇ den Ausgang des zweiten Operationsverstärkers 16 mit dessen invertierendem Eingang bzw. dem vierten Kondensator C₄.

Bei der realen Umsetzung der gegenständlichen Signalaufbereitungsschaltung 1 ist besonderes Augenmerk auf die Übergänge an den jeweiligen Grenzfrequenzen zu legen. Dabei ist es an sich unerheblich ob die Grenzfrequenzen jeweils zufolge der verbreiteten Definition, als die Frequenz angegeben werden, bei der ein Signal eine Abschwächung von -3dB aufweist, solange die jeweiligen Komponenten aufeinander abgestimmt sind, um in Summe einen möglichst glatten Übergang bzw. eine möglichst einheitliche Integration zu erzielen.

Weiters sei festgehalten, dass die messsignalführenden Bereiche der gegenständlichen Signalaufbereitungsschaltung 1 voll analog ausgeführt sind. Der komplette Signalpfad 2 ist frei von Analog/Digital-Wandlern bzw. Digital/Analog - Wandlern. Allerdings können Komponenten abseits des Signalpfades 2, wie insbesondere die aktive Regeleinheit 13 digitale Teile aufweisen. Es hat sich gezeigt, dass für die bevorzugte Anwendung der Blitzmessung Digitalschaltungen nicht geeignet sind.

## Patentansprüche

1. Signalaufbereitungsschaltung (1) mit wenigstens einem Signalpfad (2) zwischen einem Eingang (3) und einem Ausgang (4) der Signalaufbereitungsschaltung (1), wobei der Signalpfad (2) ein erstes passives Integrierglied (5) und einen aktiven Integrator (6) aufweist, wobei der aktive Integrator (6) als nichtinvertierender aktiver Integrator (6) ausgebildet ist, wobei das erste passive Integrierglied (5) und der aktive Integrator (6) seriell innerhalb des Signalpfades (2) geschaltet sind, **dadurch gekennzeichnet, dass** der aktive Integrator (6) zur Integration von Signalanteilen eines Eingangssignals mit einer Frequenz zwischen 0 Hz und einer ersten Grenzfrequenz f_{g1} ausgebildet ist, dass das erste passive Integrierglied (5) zur Integration von Signalanteilen mit einer Frequenz oberhalb der ersten Grenzfrequenz f_{g1} ausgebildet ist, dass der Signalpfad (2) weiters ein zweites passives Integrierglied (7) sowie ein Differentierglied (20) aufweist, und dass das zweite passive Integrierglied (7) zur Integration von Signalanteilen des Eingangssignals mit einer Frequenz ausgebildet ist, welche lediglich zwischen der ersten Grenzfrequenz f_{g1} und einer zweiten Grenzfrequenz f_{g2} liegt, wobei die zweite Grenzfrequenz f_{g2} größer der ersten Grenzfrequenz f_{g1} ist.

2. Signalaufbereitungsschaltung (1) nach Anspruch 1, **dadurch gekennzeichnet, dass** das Differentierglied (20) zur Kompensation der integrierenden Wirkung des zweiten passiven Integriergliedes (7) ausgebildet ist.

3. Signalaufbereitungsschaltung (1) nach Anspruch 1 oder 2, **dadurch gekennzeichnet, dass** das Differentierglied (20) zur Differentiation von Signalanteilen des Eingangssignals lediglich zwischen der ersten Grenzfrequenz f_{g1} und der zweiten Grenzfrequenz f_{g2} ausgebildet ist.

4. Signalaufbereitungsschaltung (1) nach einem der Ansprüche 1 bis 3, **dadurch gekennzeichnet, dass** das Differentierglied (20) dem aktiven Integrator (6) seriell nachgeschaltet ist.

5. Signalaufbereitungsschaltung (1) nach einem der Ansprüche 1 bis 4, **dadurch gekennzeichnet, dass** am Eingang (3) eine Temperaturkompensationsschaltung (9) zur Kompensation eines temperaturabhängigen Innenwiderstandes (Rᵢ) einer vorgebbaren, an den Eingang anschließbaren Strommessspule (10) angeordnet ist.

6. Signalaufbereitungsschaltung (1) nach Anspruch 5, **dadurch gekennzeichnet, dass** das erste passive Integrierglied (5) als Tiefpass umfassend einen ersten Widerstand (R₁) ausgebildet ist, und dass der erste Widerstand (R₁) umfassend die Temperaturkompensationsschaltung (9) ausgebildet ist.

7. Signalaufbereitungsschaltung (1) nach einem der Ansprüche 1 bis 6, **dadurch gekennzeichnet, dass** die Signalaufbereitungsschaltung (1) eine Spannungsüberwachungseinheit (11) aufweist, welche mit dem Eingang (3) verbunden ist, und welche derart ausgebildet ist, dass diese bei Auftreten einer vorgebbaren Spannung am Eingang (3) ein Trigger-Signal ausgibt.

8. Signalaufbereitungsschaltung (1) nach einem der Ansprüche 1 bis 7, **dadurch gekennzeichnet, dass** der aktive Integrator (6) umfassend einen ersten Operationsverstärker (12) und einen Rückkopplungs-Kondensator (C₃) ausgebildet ist, wobei die Signalaufbereitungsschaltung (1) weiters eine aktive Regeleinheit (13) aufweist, welche mit dem Rückkopplungs-Kondensator (C₃) verbunden ist, und welche derart ausgebildet ist, dass diese die Spannung über den Rückkopplungs-Kondensator (C₃) unter einem vorgebbaren Wert, insbesondere im Wesentlichen auf null, regelt.

9. Signalaufbereitungsschaltung (1) nach Anspruch 7 und 8, **dadurch gekennzeichnet, dass** die Spannungsüberwachungseinheit (11) mit einem Betriebseingang (14) der Regeleinheit (13) verbunden ist, und dass die Regeleinheit (13) derart ausgebildet ist, dass sich diese bei Anliegen des Trigger-Signals am Betriebseingang (14) abschaltet.

10. Signalaufbereitungsschaltung (1) nach einem der Ansprüche 1 bis 9, **dadurch gekennzeichnet, dass** das Differentierglied (20) als aktiver Differentiator (8) ausgebildet ist.

11. Strommesssystem (15) mit wenigstens einer Strommessspule (10) und einer Signalaufbereitungsschaltung (1) nach einem der Ansprüche 1 bis 10, wobei die Strommessspule (10) an den Eingang (3) der Signalaufbereitungsschaltung (1) angeschlossen ist.

12. Strommesssystem (15) nach Anspruch 11, **dadurch gekennzeichnet, dass** die Strommessspule (10) wenigstens eine Rogowskispule umfasst.

13. Strommesssystem (15) nach Anspruch 12, **dadurch gekennzeichnet, dass** ein Innenwiderstand (Rᵢ) der Rogowskispule Teil des ersten Widerstandes (R₁) des ersten passiven Integrierglieds (5) ist.

14. Strommesssystem (15) nach einem der Ansprüche 11 bis 13, **dadurch gekennzeichnet, dass** das Strommesssystem (15) als Blitzstrommesssystem ausgebildet ist.

## Claims

1. Signal conditioning circuit (1) having at least one signal path (2) between an input (3) and an output (4) of the signal conditioning circuit (1), the signal path (2) having a first passive integrating element (5) and an active integrator (6), the active integrator (6) being embodied as a non-inverting active integrator (6), the first passive integrating element (5) and the active integrator (6) being connected in series within the signal path (2), **characterized in that** the active integrator (6) is embodied for integrating signal components of an input signal having a frequency between 0 Hz and a first cut-off frequency f_{g1}, **in that** the first passive integrating element (5) is embodied for integrating signal components with a frequency above the first cut-off frequency f_{g1}, **in that** the signal path (2) furthermore has a second passive integrating element (7) and a differentiating element (20), and **in that** the second passive integrating element (7) is embodied for integrating signal components of the input signal with a frequency which is only between the first cut-off frequency f_{g1} and a second cut-off frequency f_{g2}, the second cut-off frequency f_{g2} being greater than the first cut-off frequency f_{g1}.

2. Signal conditioning circuit (1) according to claim 1, **characterized in that** the differentiator (20) is embodied for compensating the integrating effect of the second passive integrating element (7).

3. Signal conditioning circuit (1) according to claim 1 or 2, **characterized in that** the differentiator (20) is embodied for differentiating signal components of the input signal only between the first cut-off frequency f_{g1} and the second cut-off frequency f_{g2}.

4. Signal conditioning circuit (1) according to one of claims 1 to 3, **characterised in that** the differentiator (20) is connected in series downstream of the active integrator (6).

5. Signal conditioning circuit (1) according to one of the claims 1 to 4, **characterized in that** a temperature compensation circuit (9) for compensating a temperature-dependent internal resistance (Rᵢ) of a predeterminable current measuring coil (10) which can be connected to the input is arranged at the input (3).

6. Signal conditioning circuit (1) according to claim 5, **characterized in that** the first passive integrating element (5) is embodied as a low-pass filter comprising a first resistor (R₁), and **in that** the first resistor (R₁) is embodied comprising the temperature compensation circuit (9).

7. Signal conditioning circuit (1) according to one of claims 1 to 6, **characterized in that** the signal conditioning circuit (1) has a voltage monitoring unit (11) which is connected to the input (3) and which is embodied in such a way that it outputs a trigger signal when a predeterminable voltage occurs at the input (3).

8. Signal conditioning circuit (1) according to one of claims 1 to 7, **characterised in that** the active integrator (6) is embodied comprising a first operational amplifier (12) and a feedback capacitor (C₃), the signal conditioning circuit (1) further having an active control unit (13) which is connected to the feedback capacitor (C₃) and which is embodied in such a way that it regulates the voltage via the feedback capacitor (C₃) below a predeterminable value, in particular essentially to zero.

9. Signal conditioning circuit (1) according to claim 7 and 8, **characterized in that** the voltage monitoring unit (11) is connected to an operating input (14) of the control unit (13), and **in that** the control unit (13) is embodied in such a way that it switches off when the trigger signal is applied to the operating input (14).

10. Signal conditioning circuit (1) according to one of claims 1 to 9, **characterised in that** the differentiator (20) is embodied as an active differentiator (8).

11. Current measuring system (15) having at least one current measuring coil (10) and a signal conditioning circuit (1) according to one of claims 1 to 10, the current measuring coil (10) being connected to the input (3) of the signal conditioning circuit (1).

12. A current measuring system (15) according to claim 11, **characterized in that** the current measuring coil (10) comprises at least one Rogowski coil.

13. A current measuring system (15) according to claim 12, **characterized in that** an internal resistance (Rᵢ) of the Rogowski coil is part of the first resistance (R₁) of the first passive integrating element (5).

14. A current measuring system (15) according to any one of claims 11 to 13, **characterized in that** the current measuring system (15) is embodied as a lightning current measuring system.

## Revendications

1. Circuit de conditionnement de signaux (1) comportant au moins un trajet de signaux (2) entre une entrée (3) et une sortie (4) du circuit de conditionnement de signaux (1), le trajet de signaux (2) comportant un premier élément intégrateur passif (5) et un intégrateur actif (6), l'intégrateur actif (6) étant réalisé sous la forme d'un intégrateur actif non inverseur (6), le premier élément intégrateur passif (5) et l'intégrateur actif (6) étant connectés en série à l'intérieur du trajet du signal (2), **caractérisé en ce que** l'intégrateur actif (6) est conçu pour intégrer les composantes d'un signal d'entrée ayant une fréquence comprise entre 0 Hz et une première fréquence de coupure f_{g1}, **en ce que** le premier élément intégrateur passif (5) est conçu pour intégrer les composantes du signal ayant une fréquence supérieure à la première fréquence de coupure f_{g1}, **en ce que** le trajet du signal (2) comporte en outre un deuxième élément intégrateur passif (7) et un élément de différenciation (20), et **en ce que** le second élément d'intégration passif (7) est conçu pour intégrer les composantes du signal d'entrée avec une fréquence qui est seulement comprise entre la première fréquence de coupure f_{g1} et une seconde fréquence de coupure f_{g2}, la seconde fréquence de coupure f_{g2} étant supérieure à la première fréquence de coupure f_{g1}.

2. Circuit de conditionnement de signaux (1) selon la revendication 1, **caractérisé en ce que** le différentiateur (20) est conçu pour compenser l'effet d'intégration du second élément intégrateur passif (7).

3. Circuit de conditionnement du signal (1) selon la revendication 1 ou 2, **caractérisé en ce que** le différentiateur (20) est conçu pour différencier les composantes du signal d'entrée uniquement entre la première fréquence de coupure f_{g1} et la deuxième fréquence de coupure f_{g2}.

4. Circuit de conditionnement du signal (1) selon l'une des revendications 1 à 3, **caractérisé en ce que** le différentiateur (20) est connecté en série en aval de l'intégrateur actif (6).

5. Circuit de conditionnement du signal (1) selon l'une des revendications 1 à 4, **caractérisé en ce qu'**un circuit de compensation de la température (9) destiné à compenser une résistance interne (Rᵢ) dépendant de la température d'une bobine de mesure du courant prédéterminée (10) qui peut être connectée à l'entrée est disposé à l'entrée (3).

6. Circuit de conditionnement de signaux (1) selon la revendication 5, **caractérisé en ce que** le premier élément d'intégration passif (5) est réalisé comme un filtre passe-bas comprenant une première résistance (R₁), et **en ce que** la première résistance (R₁) est réalisée en comprenant le circuit de compensation de température (9).

7. Circuit de conditionnement de signaux (1) selon l'une des revendications 1 à 6, **caractérisé en ce que** le circuit de conditionnement de signaux (1) possède une unité de surveillance de la tension (11) qui est connectée à l'entrée (3) et qui est réalisée de telle sorte qu'elle émet un signal de déclenchement lorsqu'une tension prédéterminée apparaît à l'entrée (3).

8. Circuit de conditionnement de signaux (1) selon l'une des revendications 1 à 7, **caractérisé en ce que** l'intégrateur actif (6) comprend un premier amplificateur opérationnel (12) et un condensateur de rétroaction (C₃), le circuit de conditionnement de signaux (1) ayant en outre une unité de commande active (13) qui est connectée au condensateur de rétroaction (C₃) et qui est conçue de manière à réguler la tension via le condensateur de rétroaction (C₃) en dessous d'une valeur prédéterminée, en particulier essentiellement à zéro.

9. Circuit de conditionnement de signaux (1) selon les revendications 7 et 8, **caractérisé en ce que** l'unité de surveillance de la tension (11) est connectée à une entrée de fonctionnement (14) de l'unité de commande (13), et **en ce que** l'unité de commande (13) est réalisée de telle sorte qu'elle s'éteint lorsque le signal de déclenchement est appliqué à l'entrée de fonctionnement (14).

10. Circuit de conditionnement de signaux (1) selon l'une des revendications 1 à 9, **caractérisé par le fait que** le différentiateur (20) est un différentiateur actif (8).

11. Système de mesure de courant (15) comportant au moins une bobine de mesure de courant (10) et un circuit de conditionnement de signal (1) selon l'une des revendications 1 à 10, la bobine de mesure de courant (10) étant connectée à l'entrée (3) du circuit de conditionnement de signal (1).

12. Système de mesure de courant (15) selon la revendication 11, **caractérisé en ce que** la bobine de mesure de courant (10) comprend au moins une bobine de Rogowski.

13. Système de mesure de courant (15) selon la revendication 12, **caractérisé en ce qu'**une résistance interne (Rᵢ) de la bobine de Rogowski fait partie de la première résistance (R₁) du premier élément intégrateur passif (5).

14. Système de mesure de courant (15) selon l'une quelconque des revendications 11 à 13, **caractérisé en ce que** le système de mesure de courant (15) est un système de mesure de courant de foudre.
